# FASCICULE DE BREVET EUROPEEN

(11) **EP 1 153 312 B1**
(45) Date de publication et mention de la délivrance du brevet: **02.03.2005**
(21) Numéro de dépôt: 00985436.5
(22) Date de dépôt: 14.12.2000
(51) Int. Cl.: G01R 33/04

(54) **MICROMAGNETOMETRE A PORTE DE FLUX A DETECTION PERPENDICULAIRE ET SON PROCEDE DE REALISATION**
SENKRECHT DETEKTIERENDES FLUXGATE-MIKROMAGNETOMETER UND VERFAHREN ZU SEINER HERSTELLUNG
PERPENDICULAR DETECTION FLUXGATE MICROMAGNETOMETER AND METHOD FOR THE PRODUCTION THEREOF

(30) Priorité: 17.12.1999 FR 9915961
(43) Date de publication de la demande: 14.11.2001
(73) Titulaire: Commissariat à l'Energie Atomique, 75752 Paris 15ème (FR)
(72) Inventeur: FEDELI, Jean-Marc, F-38120 Saint-Egreve (FR); CUCHET, Robert, F-38000 Grenoble (FR); DURET, Denis, F-38100 Grenoble (FR); GAUD, Pierre, F-38500 Coublevie (FR)
(74) Mandataire: Poulin, Gérard
(86) Numéro de dépôt international: PCT/FR2000/003521
(87) Numéro de publication internationale: WO 2001/044826

(56) Documents cités:
- GB-A- 721 731
- US-A- 4 623 842
- US-A- 5 199 178

## Description

### Domaine technique

La présente invention a pour objet un magnétomètre à porte de flux à détection perpendiculaire et son procédé de réalisation. Elle trouve une application en magnétométrie et plus particulièrement dans :
- la localisation et l'orientation d'instruments médicaux,
- le contrôle non destructif,
- la mesure d'attitude sur systèmes de visée,
- l'aide à la navigation,
- le contrôle de trafic et d'accès,
- la cartographie magnétique.

### Etat de la technique antérieure

Les magnétomètres dits "à porte de flux" (ou "à vanne de flux" dits encore "fluxgate" en anglais) utilisent les propriétés des matériaux ferromagnétiques saturables. Un magnétomètre de ce type est décrit dans US 4 623 842 A et comprend en général un barreau ferromagnétique, un bobinage d'excitation et un bobinage de détection. Un courant variable (sinusoïdal ou triangulaire) circule dans le bobinage d'excitation et crée un champ magnétique variable, donc une induction variable dans le barreau. Dès que la saturation du matériau est atteinte, la perméabilité du barreau décroît fortement. Un champ supplémentaire qui serait appliqué ne conduirait pas à une augmentation sensible de l'induction, comme si la "porte" offerte au flux magnétique était fermée. En revanche, lors des passages par zéro du courant dans le bobinage d'excitation, la perméabilité du matériau est grande et la "porte" est ouverte au flux. D'où l'expression "porte de flux".

L'induction variable dans le barreau produit en retour un flux magnétique variable dans le bobinage de détection, ce qui entraîne l'apparition d'un signal électrique aux bornes de ce bobinage. La présence d'un champ magnétique extérieur produit une distorsion dans ce signal et l'étude de ces distorsions permet de déterminer le champ extérieur.

Le développement de la microtechnologie magnétique a permis la réalisation de micromagnétomètres de ce type ("microfluxgate"). Par la technique du dépôt électrolytique notamment, on sait réaliser des couches magnétiques et des bobinages à nappes de conducteurs de très petites dimensions. On peut trouver une description de ces micromagnétomètres à porte de flux dans les articles suivants :
- "Microfluxgate magnetic sensing elements using closely-coupled excitation and pickup coils" par Shoji KAWAHITO et al. dans "Transducers 95-Eurosensors" IX 290-A12 ;
- "A miniaturized magnetic field sensor system consisting of a planar fluxgate sensor and a CMOS readout circuitry" par R. GOTTFRIED-GOTTFRIED et al. dans "Sensors and Actuators" A 54 (1996), 443-447 ;
- "High-resolution microfluxgate sensing éléments using closely coupled coil structures" par Shoji KAWAHITO et al. dans "Sensors and Actuators" A 54 (1996) 612-617 ;
- "A microfluxgate magnetic sensor using micromachined 3-Dimensional planar coils" par Trifon M. Liakopoulos et al. dans "Solid State Sensor and Actuator Workshop", June 98.
- US 5 199 178 A

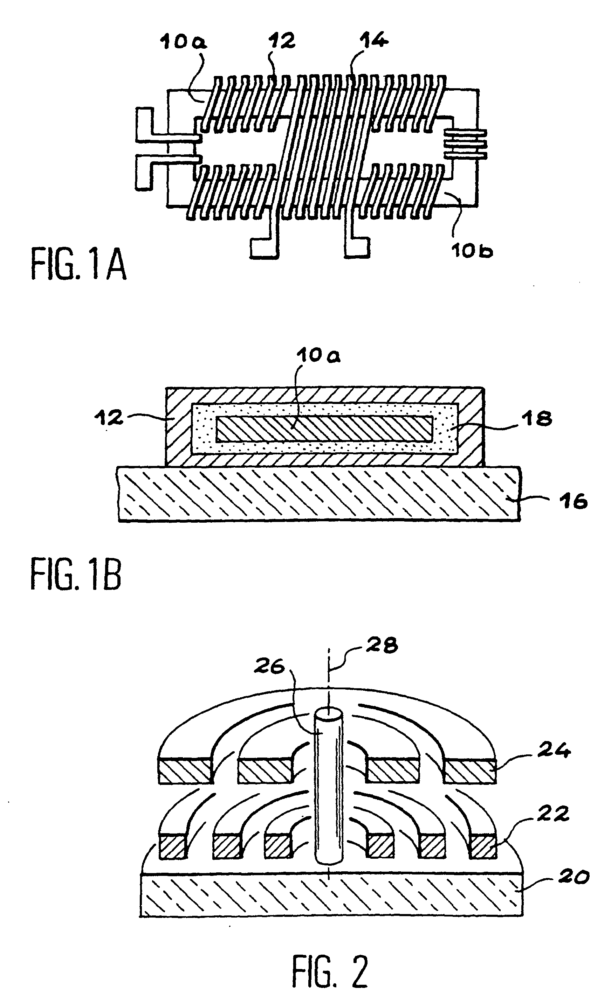

Les figures 1A et 1B montrent, en vue de dessus et en coupe, un micromagnétomètre à porte de flux connu. Tel que représenté, il se compose de deux barreaux ferromagnétiques 10a et 10b, d'un double bobinage d'excitation 12 et d'un bobinage de détection 14. L'ensemble est réalisé sur un substrat non magnétique 16, par exemple en silicium. La coupe de la figure 1B correspond à un plan passant par un des rubans du bobinage 12.

Dans le montage illustré, le bobinage de détection 14 ne voit aucun flux global puisque les inductions dans les deux barreaux 10a et 10b sont de sens opposés. Mais en présence d'un champ extérieur, l'équilibre est rompu et le signal détecté aux bornes du bobinage 14 reflète ce champ extérieur. Plus précisément, ce signal reflète la composante du champ parallèle au substrat 16 et, de plus, parallèle à l'axe longitudinal des barreaux 10a et 10b.

Dans certaines applications, il est nécessaire de connaître l'amplitude du champ et sa direction, de sorte qu'il faut mesurer les trois composantes du champ selon trois directions orthogonales. Les micromagnétomètres connus sont sensibles à la composante du champ parallèle au substrat et donc permettent cette mesure selon deux directions orthogonales X et Y, si l'on dispose deux micromagnétomètres analogues sur un même substrat et si on leur donne des directions de travail orthogonales (respectivement X et Y). Avec deux micromagnétomètres analogues orientés selon Y et Z, on obtiendra les composantes du champ selon Y et Z. Donc, finalement, avec trois micromagnétomètres analogues orientés selon X, Y et Z, on peut obtenir les trois composantes souhaitées. En général, on assemble les deux micromagnétomètres sur les deux faces adjacentes d'un cube. Cependant, la précision de la mesure reste entachée d'erreurs dues à une découpe défectueuse du cube (défaut d'orthogonalité des faces) ou à un mauvais positionnement des magnétomètres lors du collage, etc...

La présente invention a justement pour but de remédier à ces inconvénients.

### Exposé de l'invention

A cette fin, l'invention propose un micromagnétomètre qui est sensible à la composante du champ perpendiculaire au substrat (et non plus parallèle à celui-ci), autrement dit à la composante dirigée selon l'axe Z si les axes X et Y sont parallèles au substrat. Dès lors, la mesure des trois composantes d'un champ peut s'obtenir en combinant au micromagnétomètre de l'invention donnant la composante selon Z deux micromagnétomètres classiques disposés sur le même substrat et donnant les composantes selon X et Y.

De façon précise, la présente invention a pour objet un micromagnétomètre à porte de flux comprenant un substrat et, sur ce substrat, au moins un coeur ferromagnétique entouré d'au moins un bobinage d'excitation et d'au moins un bobinage de détection, ce coeur et ces bobinages ayant même axe, ce micromagnétomètre étant caractérisé en ce que ledit axe est perpendiculaire au substrat.

La présente invention a également pour objet un procédé de réalisation d'un tel micromagnétomètre caractérisé en ce que :
- on part d'un substrat non magnétique dont au moins une partie est en un matériau isolant ;
- on forme dans ce matériau isolant deux bobinages conducteurs entourant une zone centrale ;
- on grave cette zone centrale pour former une empreinte d'axe perpendiculaire au substrat ;
- on remplit cette empreinte de matériau ferromagnétique.

### Brève description des dessins

- les figures 1A et 1B, déjà décrites, montrent un micromagnétomètre à porte de flux selon l'état de la technique ;
- la figure 2 montre un micromagnétomètre selon l'invention dans un mode de réalisation où le coeur est constitué d'une seule pièce magnétique ;
- les figures 3A et 3B montrent un micromagnétomètre dans un mode de réalisation où le coeur est formé d'aiguilles ;
- la figure 4 montre un micromagnétomètre double à montage différentiel ;
- la figure 5 illustre une variante à circuit magnétique fermé ;
- la figure 6 illustre un mode de réalisation à double bobinage d'excitation ;
- la figure 7 illustre un mode de réalisation dans lequel les bobinages sont situés dans un même plan ;
- la figure 8 montre un micromagnétomètre apte à mesurer deux composantes orthogonales d'un champ magnétique.

### Description détaillée de modes particuliers de réalisation

La figure 2 illustre un cas simple où le coeur ferromagnétique est constitué par un barreau unique. On voit ainsi un substrat 20, par exemple en silicium, un bobinage de détection 22, un bobinage d'excitation 24 (tous deux, par exemple, en cuivre) et un coeur ferromagnétique 26 (par exemple en FeNi). Les bobinages 22 et 24 ainsi que le coeur 26 ont même axe, référencé 28, axe qui est perpendiculaire au substrat 20.

La section du barreau 26 peut être quelconque : carrée, rectangulaire, circulaire, ovoïde, etc... La forme des bobinages peut être, elle aussi, quelconque : circulaire, carrée, en spirale, etc... l'essentiel étant que ces bobinages entourent au moins en partie le coeur. La section droite de ces bobinages peut être carrée ou rectangulaire ou autre. Le bobinage de détection n'est pas nécessairement situé sous le bobinage d'excitation, la situation inverse de celle illustrée étant possible.

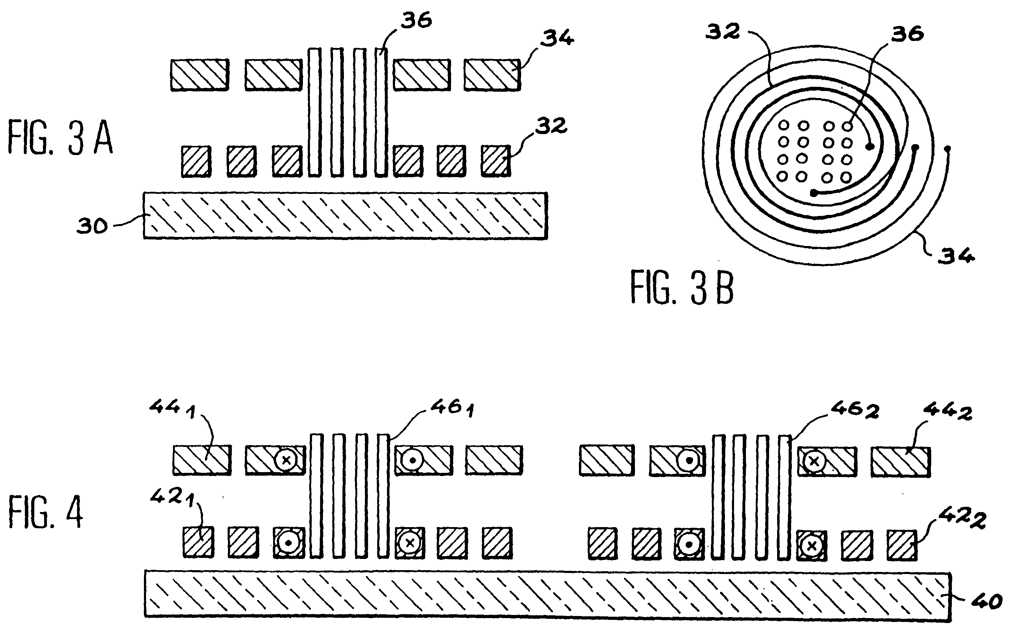

Sur les figures 3A et 3B, on voit un micromagnétomètre où le coeur n'est plus constitué d'un barreau unique mais d'une pluralité d'aiguilles ferromagnétiques. La figure 3A est une vue en coupe et la figure 3B une vue de dessus schématique. Un substrat 30 supporte un bobinage de détection 32 et un bobinage d'excitation 34, le coeur 36 étant supposé formé de 16 aiguilles réparties en carré (ce nombre et cette disposition n'étant naturellement donnés qu'à titre d'exemples). Cette disposition présente, par rapport à la précédente, l'avantage de réduire pour une épaisseur totale donnée de matériau magnétique, ce qui réduit l'effet des champs démagnétisants qui deviendraient excessifs pour certaines épaisseurs.

La figure 4 montre, sur un même substrat 40, un premier bobinage de détection 42₁ et un premier bobinage d'excitation 44₁ entourant un premier coeur ferromagnétique 46₁, ainsi qu'un second bobinage de détection 42₂ et un second bobinage d'excitation 44₂ entourant un second coeur ferromagnétique 46₂ disposé à côté du premier. Les premiers bobinages 42₁, 44₁ et les seconds bobinages 42₂, 44₂ sont connectés selon un montage en opposition. On entend par là un montage tel que les flux magnétiques F₁ et F₂ dans les coeurs 46₁, 46₂ soient de sens opposés. Les cercles marqués d'une croix ou d'un point montrent le sens du courant circulant dans les conducteurs (vers l'arrière de la feuille pour la croix, vers l'avant de la feuille pour le point). L'ensemble fonctionne dès lors en différentiel.

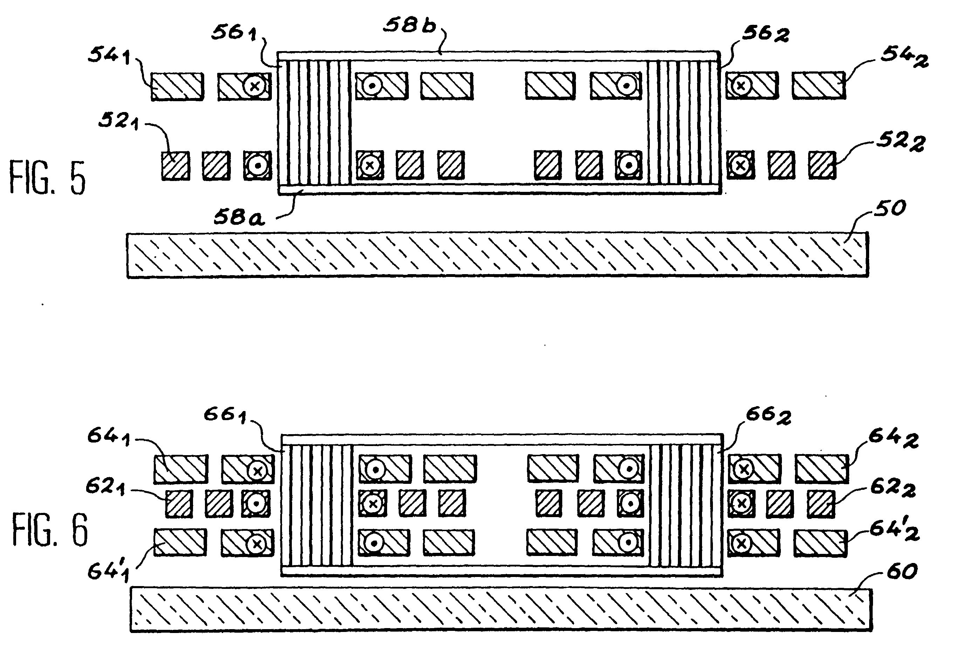

Sur la figure 5, l'ensemble représenté comprend encore un substrat 50, deux bobinages de détection 52₁, 52₂, deux bobinages d'excitation 54₁, 54₂ et deux coeurs 56₁, 56₂. Il comprend en outre deux branches magnétiques 58a, 58b parallèles au substrat 50 et reliant entre eux les deux coeurs 56₁, 56₂. Toutes les pièces magnétiques constituent donc un circuit fermé.

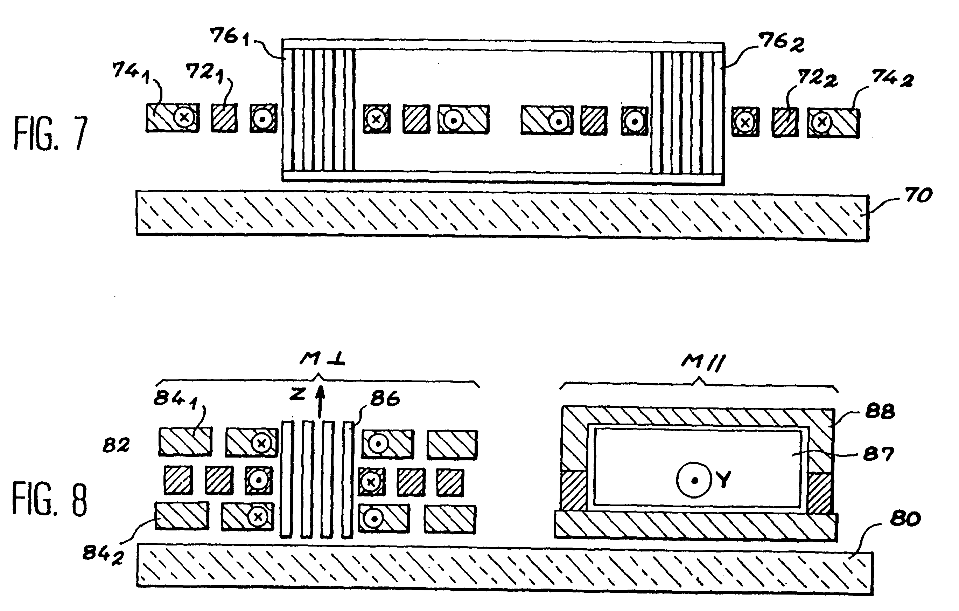

Afin d'améliorer l'excitation, on peut ajouter un deuxième niveau d'excitation comme illustré sur la figure 6. On y voit un substrat 60, un bobinage de détection 62₁, 62₂, un bobinage d'excitation double 64₁, 64₁, 64₂, 64₂. Le bobinage de détection est situé sur un niveau intermédiaire disposé entre les deux niveaux du bobinage double d'excitation. L'ensemble est encore connecté en différentiel.

Les bobinages d'excitation et de détection ne sont pas nécessairement disposés sur des niveaux différents mais peuvent occuper un même niveau comme illustré sur la figure 7. On y voit un substrat 70, un bobinage de détection 72₁, 72₂, un bobinage d'excitation 74₁, 74₂ et deux coeurs 76₁, 76₂. Le bobinage de détection 72₁, 72₂ a ses spires disposées entre les spires du bobinage d'excitation, toutes ces spires étant placées dans un même plan. L'ensemble est encore connecté en différentiel.

La figure 8 montre un micromagnétomètre composite comprenant un premier micromagnétomètre M_{⊥} conforme à l'invention et un deuxième micromagnétomètre M_{//} conforme à l'art antérieur. Ces deux micromagnétomètres partagent le même substrat 80. Le micromagnétomètre M₁ comprend un enroulement de détection 82 et un double enroulement d'excitation 84₁, 84₂ ainsi qu'un coeur ferromagnétique 86. Il permet la mesure de la composante du champ selon une direction perpendiculaire au substrat 80 (flèche Z). Le deuxième magnétomètre M_{//} comprend un coeur ferromagnétique 87 et des bobinages d'excitation et de détection 88 (on ne voit, en coupe, qu'une spire), le coeur et les bobinages ayant un même axe parallèle au substrat 80 (comme sur la figure 1B). Ce deuxième micromagnétomètre M_{//} permet la mesure de la composante du champ selon une direction parallèle au substrat (flèche Y perpendiculaire au plan de la feuille).

Un troisième micromagnétomètre analogue au deuxième mais orienté selon une direction X perpendiculaire à Y et Z peut être disposé sur le même substrat 80, pour obtenir un dispositif sensible aux trois composantes de n'importe quel champ.

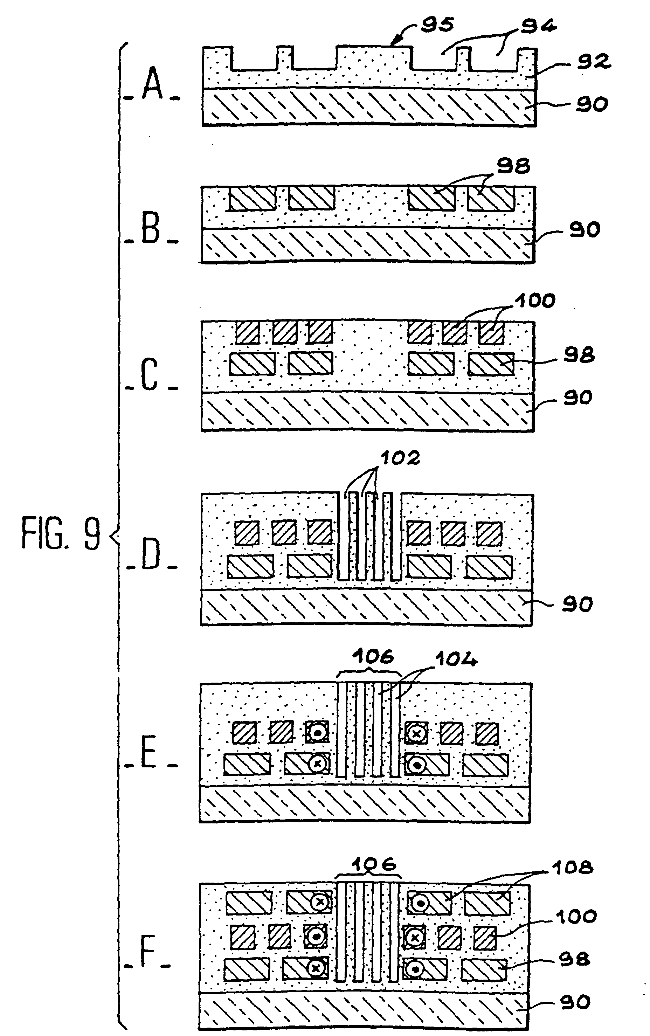

La figure 9 illustre, enfin, un procédé de réalisation d'un micromagnétomètre selon l'invention. Cette figure se rapporte au cas particulier d'un coeur à pluralité d'aiguilles avec double bobinage d'excitation, mais il va de soi que le procédé de l'invention n'est pas limité à ce cas.

On part d'un substrat non magnétique 90, par exemple en silicium. Sur ce substrat, on dépose une couche 92 de matériau isolant, par exemple de la silice obtenue par oxydation thermique. On pourrait également prendre comme substrat, un substrat de verre. Dans ce dernier cas, il n'est pas nécessaire de déposer une couche isolante. On forme dans ce matériau isolant, par exemple par photolithographie et gravure, une empreinte 94 ayant la forme du bobinage recherché et entourant la zone centrale 95 qui sera occupée par la suite par le coeur ferromagnétique (partie A).

De préférence par croissance électrolytique d'un matériau conducteur (cuivre par exemple), on comble l'empreinte pour obtenir un bobinage 98 (partie B).

On réitère ces opérations (nouvelle couche d'isolant, gravure d'une empreinte, dépôt électrolytique) pour réaliser un deuxième bobinage 100 (partie C). On redépose une couche d'isolant.

Dans la zone centrale 95, on grave des tubes 102 destinés à recevoir les futures aiguilles du coeur (partie D).

De préférence par croissance électrolytique de matériau ferromagnétique (par exemple FeNi), on comble les tubes 102 et l'on obtient le coeur 104 (partie E).

Par de nouvelles opérations de photolithographie, gravure et dépôt électrolytique, on forme un bobinage 108 (partie F), que l'on isole ensuite.

Le bobinage 100 constituera un bobinage de détection et les bobinages 98, 108 un double bobinage d'excitation.

## Revendications

1. Micromagnétomètre à porte de flux comprenant un substrat (20, 30, 40, 50, 60, 70, 80, 90) et, sur ce substrat, au moins un coeur oblongue ferromagnétique (26, 36, 46₁, 46₂, 56₁, 56₂, 66₁, 66₂, 86) ayant un axe longitudinal (28) et entouré d'au moins un bobinage d'excitation (22, 32, 42₁, 42₂, 52₁, 52₂, 62, 72, 82) et d'au moins un bobinage de détection, ce coeur et ces bobinages ayant même axe (28), **caractérisé en ce que** ledit axe (28) est perpendiculaire au substrat (20, 30, 40, 50, 60, 70, 80, 90).

2. Micromagnétomètre selon la revendication 1, dans lequel le coeur présente la forme d'un barreau unique (26).

3. Micromagnétomètre selon la revendication 1, dans lequel le coeur (36, 46₁, 46₂, 56₁, 56₂, 66₁, 66₂, 76₁, 76₂, 86) est formé d'une pluralité d'aiguilles.

4. Micromagnétomètre selon la revendication 1, comprenant, sur un même substrat (40, 50, 60, 70), un premier coeur ferromagnétique (46₁, 56₁, 66₁, 76₁) entouré d'un premier bobinage d'excitation (44₁, 54₁, 64₁, 64₁, 74₁) et d'un premier bobinage de détection (42₁, 52₁, 62₁, 72₁, 82) et un second coeur ferromagnétique (46₂, 56₂, 64₂, 66₂ , 76₂) disposé à côté du premier, entouré d'un second bobinage d'excitation (44₂, 54₂, 64₂, 64₂ , 74₂) et d'un second bobinage de détection (42₂, 52₂, 62₂, 62₂, 72₂) , lesdits seconds bobinages et lesdits premiers bobinages étant connectés en différentiel.

5. Micromagnétomètre selon la revendication 4, comprenant en outre deux branches magnétiques (58a, 58b) parallèles au substrat (50) et reliant le premier (56₁) et le second (56₂) coeurs ferromagnétiques, l'ensemble branches-coeurs (56₁, 58a, 56₂, 58b) formant un circuit magnétique fermé.

6. Micromagnétomètre selon la revendication 1, dans lequel le bobinage d'excitation et le bobinage de détection sont placés sur des niveaux différents par rapport au substrat.

7. Micromagnétomètre selon la revendication 1, dans lequel le bobinage d'excitation et le bobinage de détection sont placés sur un même niveau par rapport au substrat.

8. Micromagnétomètre selon la revendication 6, dans lequel le bobinage d'excitation est double (64₁, 64₁') (64₂, 64₂') et occupe deux niveaux superposés, le bobinage de détection (62₁, 62₂) étant situé sur un niveau disposé entre les deux niveaux du bobinage double d'excitation.

9. Micromagnétomètre comprenant un premier micromagnétomètre (M_{┴}) selon l'une quelconque des revendications 1 à 8, et, sur le même substrat (80), un deuxième micromagnétomètre (M_{//}) ayant un axe de détection parallèle (Y) au substrat (80).

10. Micromagnétomètre selon la revendication 9, comprenant en outre un troisième micromagnétomètre ayant un axe de détection parallèle (X) au substrat (80) et perpendiculaire à l'axe de détection (Y) du deuxième magnétomètre (M_{//}) .

11. Procédé de réalisation d'un micromagnétomètre selon la revendication 1, **caractérisé en ce que** :
- on part d'un substrat non magnétique (90), dont au moins une partie est un matériau isolant ;
- on forme dans ce matériau isolant deux bobinages conducteurs (98, 100) entourant une zone centrale (95) ;
- on grave cette zone centrale (95) pour former une empreinte oblongue 102) d'axe longitudinal perpendiculaire au substrat (90) ;
- on remplit cette empreinte de matériau ferromagnétique (104).

12. Procédé selon la revendication 11, dans lequel pour former l'empreinte on grave une pluralité de trous (102) dans l'isolant, perpendiculairement au substrat (90).

13. Procédé selon l'une quelconque des revendications 11 et 12, dans lequel on remplit l'empreinte réalisée dans la zone centrale (95) par croissance électrolytique d'un matériau ferromagnétique.

14. Procédé selon la revendication 11, dans lequel, pour former un bobinage conducteur, on forme, dans le matériau isolant (92), par photolithographie et gravure, une empreinte (94) ayant la forme du bobinage recherché et entourant la zone centrale (95) et on comble cette empreinte par un matériau conducteur (98).

## Patentansprüche

1. Fluxgate-Mikromagnetometer, ein Substrat (20, 30, 40, 50, 60, 70, 80, 90) und - auf diesem Substrat - wenigstens einen länglichen ferromagnetischen Kern (26, 36, 46₁, 46₂, 56₁, 56₂, 66₁, 66₂, 86) umfassend, der umgeben ist von wenigstens einer Erregerwicklung (22, 32, 42₁, 42₂, 52₁ 52₂, 62, 72, 82) und wenigstens einer Detektionswicklung, wobei dieser Kern und diese Wicklungen dieselbe Achse (28) haben,
**dadurch gekennzeichnet, dass** die genannte Achse (28) senkrecht zu dem Substrat (20, 30, 40, 50, 60, 70, 80, 90) ist.

2. Mikromagnetometer nach Anspruch 1, bei dem der Kern die Form eines einzigen Stabs (26) aufweist.

3. Mikromagnetometer nach Anspruch 1, bei dem der Kem (36, 46₁, 46₂, 56₁, 56₂, 66₁, 66₂, 76₁, 76₂, 86) durch eine Vielzahl von Nadeln gebildet wird.

4. Mikromagnetometer nach Anspruch 1, mit - auf einem selben Substrat (40, 50, 60, 70) - einem ersten ferromagnetischen Kem (46₁, 56₁, 66₁, 76₁), umgeben von einer ersten Erregerwicklung (44₁, 54₁, 64₁, 64₁', 74₁) und einer ersten Detektionswicklung (42₁, 52₁, 62₁, 72₁, 82), und einem zweiten ferromagnetischen Kern (46₂, 56₂, 64₂, 66₂, 76₂), angeordnet neben dem ersten und umgeben von einer zweiten Erregerwicklung (44₂, 54₂, 64₂, 64₂', 74₂) und einer zweiten Detektionswicklung (42₂, 52₂, 62₂, 62₂', 72₂), wobei die genannten zweiten Wicklungen und die genannten ersten Wicklungen differential angeschlossen bzw. geschaltet sind.

5. Mikromagnetometer nach Anspruch 4, mit außerdem zwei magnetischen Schenkeln (58a, 58b), die parallel sind zum Substrat (50) und die den ersten (56₁) und den zweiten (56₂) ferromagnetischen Kem verbinden, wobei die Schenkel-Kerne-Einheit (56₁, 58a, 56₂, 58b) einen geschlossenen Magnetkreis bildet.

6. Mikromagnetometer nach Anspruch 1, bei dem sich die Erregerwicklung und die Detektionswicklung in Bezug auf das Substrat in unterschiedlichen Ebenen befinden.

7. Mikromagnetometer nach Anspruch 1, bei dem sich die Erregerwicklung und die Detektionswicklung in Bezug auf das Substrat in derselben Ebene befinden.

8. Mikromagnetometer nach Anspruch 6, mit einer Erreger-Doppelwicklung (64₁, 64₁') (64₂, 64₂'), die zwei übereinanderüegende Ebenen besetzen, wobei die Detektionswicklung (62₁, 62₂) sich in einer Ebene zwischen den beiden Ebenen der Erreger-Doppelwicklung befindet.

9. Mikromagnetometer, ein Mikromagnetometer nach einem der Ansprüche 1 bis 8 umfassend sowie - auf demselben Substrat (80) - ein zweites Mikromagnetometer (M_{//}) mit einer zu dem Substrat (80) parallelen Detektionsachse (Y).

10. Mikromagnetometer nach Anspruch 9, außerdem ein drittes Mikromagnetometer mit einer Detektionsachse (X) umfassend, die parallel ist zu dem Substrat (80) und senkrecht zu der Detektionsachse (Y) des zweiten Magnetometers M_{//}.

11. Verfahren zur Realisierung eine Mikromagnetometers nach Anspruch 1,
**dadurch gekennzeichnet, dass** man wie folgt vorgeht:
- man beginnt mit einem nichtmagnetischen Substrat (90), von dem wenigstens ein Teil durch ein isolierendes Material gebildet wird;
- man bildet in diesem isolierenden Material zwei leitfähige Wicklungen (98, 100), die eine zentrale Zone (95) umgeben;
- man ätzt diese zentrale Zone (95), um eine längliche Vertiefung (102) mit einer zu dem Substrat (90) senkrechten Längsachse auszubilden;
- man füllt diese Vertiefung mit ferromagnetischem Material (104).

12. Verfahren nach Anspruch 11, in welchem man zur Ausbildung der Vertiefung eine Vielzahl von Löchern (102) in das isolierende Material ätzt, senkrecht zu dem Substrat (90).

13. Verfahren nach einem der Ansprüche 11 und 12, in welchem.man die in der zentralen Zone (95) realisierte Vertiefung durch elektrolytisches Wachstum eines ferromagnetischen Materials füllt.

14. Verfahren nach Anspruch 11, in welchem man zur Ausbildung einer leitfähigen Wicklung in dem isolierenden Material (92) durch Fotolithografie und Ätzen eine Vertiefung (94) realisiert, welche die Form der genannten Wicklung hat und die zentrale Zone (95) umgibt, und dann diese Vertiefung mit einem leitfähigen Material (98) füllt.

## Claims

1. Fluxgate micro-magnetometer comprising a substrate (20, 30, 40, 50, 60, 70, 80, 90) and, on this substrate, at least one oblong ferromagnetic core (26, 36, 46₁, 46₂, 56₁, 56₂, 66₁, 66₂, 86) having a longitudinal axis (28) surrounded by at least one excitation coil (22, 32, 42₁, 42₂, 52₁, 52₂, 62, 72, 82) and at least one pick-up coil, the said core and coils having the same axis (28), **characterized in that** the said axis (38) is perpendicular to the substrate (20, 30, 40, 50, 60, 70, 80, 90).

2. Micro-magnetometer according to claim 1, wherein the core is made up of a single bar (26).

3. Micro-magnetometer according to claim 1, wherein the core (36, 46₁, 46₂, 56₁, 56₂, 66₁, 66₂, 76₁, 76₂, 86) is made up of a number of needles.

4. Micro-magnetometer according to claim 1, comprising, on a same substrate (40, 50, 60, 70), one first ferromagnetic core (46₁, 56₁, 66₁, 76₁) surrounded by a first excitation coil (44₁, 54₁, 64₁, 64₁', 74₁), and one first pick-up coil (42₁, 52₁, 62₁, 72₁, 82), and a second ferromagnetic core (46₂, 56₂, 64₂, 66₂', 76₂) located close to the first one, surrounded by a second excitation coil (44₂, 54₂, 64₂, 64₂', 74₂) and a second pick-up coil (42₂, 52₂, 62₂, 62₂', 72₂), the said second coils and the said first coils being connected in differential mode.

5. Micro-magnetometer according to claim 4, comprising also two magnetic arms (58a, 58b) parallel to the substrate (50) which are linking the first (56₁) and the second (56₂) ferromagnetic cores, the arms-cores assembly (56₁, 58a, 56₂, 58b) forming a closed magnetic circuit.

6. Micro-magnetometer according to claim 1, wherein the excitation coil and the pick-up coil are located on different levels with respect to the substrate.

7. Micro-magnetometer according to claim 1, wherein the excitation coil and the pick-up coil are located on a same level with respect to the substrate.

8. Micro-magnetometer according to claim 6, wherein the excitation coil is double (64₁, 64₁') (64₂, 64₂') and occupies two superimposed levels, the pick-up coil (62₁, 62₂) being located on an intermediate level between the two levels occupied by the double excitation coil.

9. Micro-magnetometer comprising a first micro-magnetometer (M_{┴}) according to any one of claims 1 to 8, and, on the same substrate (80), a second micro-magnetometer (M_{//}) where a detection axis is parallel to the substrate (80).

10. Micro-magnetometer according to claim 9, comprising also a third micro-magnetometer having a detection axis (X) parallel to the substrate (80) and perpendicular to the detection axis (Y) of the second magnetometer (M_{//}).

11. Process for implementing a micro-magnetometer according to claim 1, **characterized in that**:
- one uses a non-magnetic substrate (90) whose one part, at least, is made up of an insulating material;
- one creates on this insulating material two conducting coils (98, 100) surrounding a central area (95);
- one etches this central area (95) to obtain an oblong imprint (102) whose longitudinal axis is perpendicular to the substrate (90);
- one fills up this imprint with a ferromagnetic material (104).

12. Process according to claim 11, wherein, to obtain the print, one etches a number of holes (102) in the insulating part, perpendicular to the substrate (90) .

13. Process according to any one of claims 11 and 12, wherein one fills up the imprint etched in the central area (95) by electrolytic growth of a ferromagnetic material.

14. Process according to claim 11, wherein, for obtaining a conducting coil, one creates on the insulating material (92), by photolithography and etching, an imprint (94) which has the shape of the required coil and which surrounds the central area (95), then one fills-up this imprint with a conductive material (98).
